# EUROPÄISCHE PATENTSCHRIFT

(11) **EP 3 562 578 B1**
(45) Veröffentlichungstag und Bekanntmachung des Hinweises auf die Patenterteilung: **10.06.2020**
(21) Anmeldenummer: 18795318.7
(22) Anmeldetag: 15.10.2018
(51) Int. Cl.: B30B 11/00, B01J 3/06

(54) **VORRICHTUNG ZUR ERZEUGUNG HOHER DRÜCKE IN FESTEN MEDIEN**
DEVICE FOR PRODUCING HIGH PRESSURES IN SOLID MEDIA
DISPOSITIF POUR GÉNÉRER DES PRESSIONS ÉLEVÉES DANS DES MILIEUX SOLIDES

(30) Priorität: 19.10.2017 EP 17197358
(43) Veröffentlichungstag der Anmeldung: 06.11.2019
(73) Patentinhaber: EcoDiamond GmbH, 18196 Kavelstorf (DE)
(72) Erfinder: FEIGELSON, Boris, Springfield, Virginia 22152 (US); KOSTYAEV, Andrey, 18258 Wiendorf (DE)
(74) Vertreter: Jeck, Anton
(86) Internationale Anmeldenummer: PCT/EP2018/078102
(87) Internationale Veröffentlichungsnummer: WO 2019/076827

(56) Entgegenhaltungen:
- JP-A- S61 103 534
- RU-C1- 2 077 375

## Beschreibung

Die Erfindung bezieht sich auf eine Vorrichtung zur Erzeugung hoher Drücke in festen und flüssigen Medien gemäß dem Oberbegriff des Anspruchs 1.

Hochdrücke sind für viele verfahrenstechnische Vorgänge bei der Herstellung verschiedener Materialien erforderlich. Es gibt viele Druckgeräte, die Drücke und Temperaturen erzeugen können, die für eine Diamantsynthese ausreichen.

Zum Stand der Technik wird auch auf Hall, H.T. (1980), High Pressure Techniques, John Wiley & Sons, Utah verwiesen.

Aus dem Stand der Technik (US 3118177, RU 2077375, US 7887631) sind ferner Vorrichtungen bekannt, um synthetische Diamanten zu züchten. Sie enthalten einen unteren und einen oberen schalenförmigen Halbkörper und eine zwischen den Halbschalen einsetzbare Spaltkugel aus acht Kugelsektoren, die auf eine zentrale Zuchtkammer einwirken. Bei anderen Ausgestaltungen kann eine zweite Stufe der oktaedrischen Kugelsektoren anstelle der Zuchtkammer angewendet werden. Diese zweite Stufe wird in einem durch acht Kugelsektoren der Spaltkugel erzeugten oktaedrischen Hohlraum angeordnet. In diesem Fall wird die Zuchtkammer in einen kubischen Raum gesetzt. Der kubische Raum wird durch die zweite Stufe der oktaedrischen Kugelsektoren erzeugt, so dass durch die Reduzierung der Oberfläche eine erhebliche Druckverstärkung auf die in der Zuchtkammer befindliche Rohmischung für die Diamantzüchtung ausgeübt wird.

Der Druck in der Zuchtkammer wird dadurch erzeugt, dass der Öldruck zwischen den Halbkörpern und einer elastischen Membran über die Membran auf Kugelsektoren der Spaltkugel übertragen wird, die dann diesen Druck auf die Zuchtkammer übertragen. Bei einer anderen Ausgestaltung übertragen die Kugelsektoren der Spaltkugel den Druck auf die kleineren Kugelsektoren einer Kugel der zweiten Stufe. Die kleineren Kugelsektoren übertragen dann den Druck in die Zuchtkammer. Die Bewegung der Kugelsektoren wird durch den Öldruck ausgelöst. Während des Betriebs erfolgt eine symmetrische Bewegung der Kugelsektoren zum Mittelpunkt der Spaltkugel hin.

Bei den aus US 3118177 und US 7887631 vorbekannten Vorrichtungen sind die Kugelsektoren in einem gemeinsamen, mit einem Hydrauliköl befüllten Druckraum beherbergt. Um Zugang zur Zuchtkammer zu erhalten, muss der Druckraum vorher durch Ablassen des Hydrauliköls entleert werden. Dies macht die Handhabung und den Umgang sehr aufwändig und unwirtschaftlich.

Bei der aus RU 2077375 vorbekannten Vorrichtung, gemäß dem Oberbegriff des Anspruchs 1, ist der Druckraum zweigeteilt.

Ein erster Druckraum ist im oberen und ein zweiter im unteren Halbkörper beherbergt. Während des Betriebs der Vorrichtung ist diese geschlossen. Dabei sind die beiden Halbkörper an einer gemeinsamen Teilungsebene zusammengeführt. Sind die beiden Halbkörper zusammengeführt, sind die Druckräume über eine Ölleitung miteinander verbunden. Die Ölleitung besteht aus zwei geraden Verbindungsleitungsabschnitten. In jedem der beiden Halbkörper ist einer der geraden Verbindungsleitungsabschnitte ausgebildet. Die Längsachsen der Verbindungsleitungsabschnitte stehen senkrecht auf der gemeinsamen Teilungsebene zwischen den beiden Halbkörpern auf. Liegen die beiden Halbkörper aufeinander, münden die beiden Verbindungsleitungsabschnitte ineinander. Zum Öffnen der Vorrichtung werden die beiden Halbkörper voneinander entfernt. Sind die beiden Halbkörper voneinander entfernt, ist die Ölleitung unterbrochen. Die beiden Verbindungsleitungsabschnitte münden dann nicht mehr ineinander, sondern münden jeweils ins Freie. Sind die beiden Halbkörper voneinander entfernt, besteht demnach keine Verbindung zwischen den beiden Druckräumen. Um beim Entfernen der beiden Halbkörper voneinander einen Austritt der gesamten Hydraulikflüssigkeit zu verhindern, sind die Verbindungsleitungsabschnitte mit Ventilen versehen. Um an die Zuchtkammer zu gelangen, können hierdurch die beiden Halbkörper voneinander entfernt werden, ohne dass die Hydraulikflüssigkeit abgelassen werden muss. Die bei Betrieb der Zuchtkammer unter Hochdruck stehenden Ventile weisen zu deren Funktion erforderliche bewegliche Teile auf. Die beweglichen Teile der Ventile unterliegen unter dem Hochdruck erheblichem Verschleiß. Demzufolge können die Ventile keine vollständige Dichtheit beim Auseinanderbewegen der beiden Halbkörper gewährleisten. Dies führt zu Ölleckverlusten sowohl bei Betrieb der Zuchtkammer unter dem dann herrschenden Hochdruck als auch beim Öffnen der Vorrichtung, um an die Zuchtkammer zu gelangen. Ein zusätzlicher Nachteil ist, dass die Ventile zumindest während des Druckaufbaus und -abbaus erhebliche Druckverluste erzeugen und damit eine Druckungleichheit in den beiden Druckräumen im oberen und im unteren Halbkörper nach sich ziehen. Diese Druckungleichheit verstärkt sich mit zunehmendem Verschleiß der beweglichen Teile der Ventile. Dies hat eine unsymmetrische Bewegung der Stempel bildenden Kugelsektoren zur Folge. Bei der unsymmetrischen Bewegung kommt es zu Schiefstellungen zwischen den Kugelsektoren. Bereits sehr geringe Schiefstellungen führen bei dem zum Betrieb der Zuchtkammer notwendigen Hochdruck zu einem Bruch der internen Stempel und/oder zu einem Materialausbruch in der Zuchtkammer. Dies macht das in der Zuchtkammer erzeugte Syntheseergebnis unbrauchbar.

Ausgehend von dem obigen Stand der Technik liegt der Erfindung die Aufgabe zugrunde, eine Vorrichtung zu schaffen, die Hochdrücke erzeugen kann, und zwar in festen und flüssigen Medien. Dabei sind die Drücke und Temperaturen für die Synthese von Diamanten und kubischen Bornitrid ausgebildet, um synthetische Diamanten und kubisches Bornitrid herzustellen. Diese Vorrichtung soll betriebssicherer und einfacher im Umgang sein sowie Syntheseergebnisse homogener Qualität liefern.

Die gestellte Aufgabe wird durch die Merkmale des Anspruchs 1 gelöst.

Die Erfindung nutzt mehrere Druckmittel, um Drücke in festen und flüssigen Medien zu erzeugen. Eine solche Vorrichtung weist einen unteren schalenförmigen Halbkörper und einen oberen schalenförmigen Halbkörper sowie eine untere elastische Membran und eine obere elastische Membran auf, die jeweils in den unteren Halbkörper und in den oberen Halbkörper eingesetzt sind. Dabei umgeben der jeweilige Halbkörper und die jeweils in ihn eingesetzte Membran jeweils einen Druckraum. Weiterhin weist die Vorrichtung eine Öffnung und einen Kanal im unteren Halbkörper auf, um eine Ölleitung von einer Ölpumpe an die Vorrichtung anzuschließen und das Öl in den Druckraum zwischen dem unteren Halbkörper und der in ihn eingesetzten elastischen Membran zu fördern.

Die Erfindung bietet Mittel, um den benötigten Druck zu erzeugen, damit superharte Stoffe synthetisiert sowie Pulver und Nanopulver unter Hochdruck gesintert werden können. Die Vorrichtung ermöglicht es insbesondere, Hochdrücke zu erzeugen und Erwärmung anzuwenden, die dafür ausreichen, Diamanten und andere superharte Stoffe zu synthetisieren und Pulver, darunter auch Diamantpulver, zu sintern.

Weitere zweckmäßige und vorteilhafte Ausgestaltungen der Erfindung gehen aus den Unteransprüchen hervor.

Erfindungsgemäß ist es vorgesehen, dass die Druckräume im unteren Halbkörper und im oberen Halbkörper mittels einer Rohrleitung permanent, das heißt sowohl in geschlossenem als auch in geöffnetem Zustand der Vorrichtung, miteinander verbunden sind, die in Form einer Schraubenfederleitung ausgebildet ist.

Eine Wickelachse der Schraubenfederleitung liegt hierbei vorteilhaft innerhalb einer gemeinsamen Teilungsebene zwischen den beiden Halbkörpern. Die gemeinsame Teilungsebene wird durch diejenige Fläche aufgespannt, an der die beiden Halbkörper bei geschlossener Vorrichtung aneinander anliegen.

Die Rohrleitung ist bevorzugt Teil einer zusätzlich zwei Verbindungsleitungsabschnitte umfassenden Ölleitung. In jedem Halbkörper ist ein Verbindungsleitungsabschnitt ausgebildet. Die Verbindungsleitungsabschnitte können durch in den jeweiligen Druckraum führende Bohrungen in den Halbkörpern verwirklicht sein.

Die die Druckräume im unteren Halbkörper und im oberen Halbkörper miteinander verbindende, die beiden Verbindungsleitungsabschnitte und die Schraubenfederleitung umfassende Ölleitung ist gemäß einer besonders vorteilhaften Ausgestaltung der Erfindung frei von Ventilen. Vorteilhaft ist sie außerdem frei von sonstigen beweglichen Teilen. Eine Torsion der mit ihren beiden Enden an die Mündungen der Verbindungsleitungen an den beiden Halbkörpern angeschlossenen Schraubenfederleitung stellt hierbei kein bewegliches Teil im Sinne der voranstehenden Bemerkung dar.

Die Verbindungsleitungsabschnitte verlaufen vorteilhaft parallel zueinander sowie parallel zu der gemeinsamen Teilungsebene. Sie treten vorteilhaft seitlich aus den Halbkörpern aus. Besonders bevorzugt treten sie auf derselben Seite seitlich aus den Halbkörpern aus, wo sie mit der Schraubenfederleitung miteinander verbunden sind.

Die vorliegende Erfindung bietet eine Vorrichtung für die Synthese von Diamanten bzw. sonstigen Kristallen, die unter Druck mittels Sinterung von metallenen, keramischen Diamantpulvern und Nanopulvern gezüchtet werden.

Nach einer Weiterbildung der Erfindung ist vorgesehen, dass der untere Halbkörper und der obere Halbkörper durch ein in einer Ausnehmung an den Halbkörpern angeordnetes Gelenk miteinander verbunden sind.

Die Gelenkachse stimmt vorteilhaft mit der Wickelachse der Schraubenfederleitung überein.

Besonders bevorzugt ist es nach einer Weiterbildung der Erfindung, dass die Schraubenfederleitung das Gelenk umfasst oder vom Gelenk umfasst wird.

Bevorzugterweise ist es vorgesehen, dass die Schraubenachse der Schraubenfederleitung mit der Gelenkachse des Gelenks übereinstimmt.

Zweckdienlicherweise kann es vorgesehen sein, dass die Vorrichtung zwei gegenüberliegende Teile eines Verschlusses umfasst, welche die Halbkörper (2, 3) aneinanderdrücken.

Besonders bevorzugt ist es, dass die Ausnehmung von wenigstens einem der zwei gegenüberliegenden Teile des Verschlusses überdeckt wird.

Nach einer Weiterbildung der vorliegenden Erfindung ist vorgesehen, dass die Schraubenfederleitung in der gleichen Ausnehmung wie das Gelenk angeordnet ist. Die Größe der Ausnehmung ermöglicht es, sowohl die Schraubenfederleitung als auch das Gelenk aufzunehmen und die beiden gegenüberliegenden Teile des Verschlusses zu verschieben, welche die Halbkörper aneinanderdrücken. Vorzugsweise ist es vorgesehen, dass der Innendurchmesser der Schraubenfederleitung die gleiche Öldruckänderungsgeschwindigkeit im unteren und im oberen Halbkörper beim Druckaufbau und -abbau sicherstellt und die Schraubenfederleitung einem Öldruck von mindestens 300 MPa (3000 atm) standhalten kann.

Besonders bevorzugt ist vorgesehen, dass sie eine in den unteren Halbkörper mit der elastischen Membran einsetzbare Spaltkugel umfasst, die aus acht Kugelsektoren (8) besteht, deren abgestumpfte Spitzen einen oktaederförmigen Hohlraum (9) bilden, welcher eine Zuchtkammer beherbergt.

Zweckdienlicherweise kann es vorgesehen sein, dass sie sechs im oktaedrischen Hohlraum platzierbare Kugelsektoren in Form von abgestumpften oktaedrischen Pyramiden umfasst, deren abgestumpfte Spitzen einen Raum in Form von einem Kubus oder einem Quader bilden, in dem die Zuchtkammer angeordnet ist.

Besonders zweckdienlich ist es nach einer Weiterbildung der Erfindung, dass sie Folgendes umfasst:
Stromanschlüsse zur Speisung des Heizkörpers in der Zuchtkammer
und/oder Messstromanschlüsse, um elektrische Signale der in sie eingebauten Temperaturfühler und Druckgeber zu übertragen,
und/oder eine Öffnung und einen Kanal im oberen Halbkörper, um die durch das Öl bei Erstölfüllung der Vorrichtung (1) verdrängte Luft auszulassen,
und/oder eine Ausnehmung im unteren Halbkörper und eine ähnliche Ausnehmung im oberen Halbkörper zur Aufnahme eines Gelenks, das das Öffnen und das Schließen der Vorrichtung sicherstellt,
und/oder ein Gelenk, das an die Halbkörper in der Ausnehmung angeschlossen wird.

Nach einer Weiterbildung der vorliegenden Erfindung ist vorgesehen, dass die Schraubenfederleitung einen Ölbypass zwischen den Halbkörpern sicherstellt, die Schraubenfederleitung auf Verdrillung und Rückverdrehung beansprucht wird, so dass der obere Halbkörper am Gelenk hoch- und zugeklappt werden kann, dass jeder der Halbkörper je eine zusätzliche Öffnung und je einen Kanal aufweist, um die Schraubenfederleitung anzuschließen und den Ölfluss zwischen der Schraubenfederleitung und dem durch den unteren Halbkörper und die elastische Membran gebildeten Druckraum und dem durch den oberen Halbkörper und der elastischen Membran gebildeten Druckraum zu ermöglichen.

Zweckdienlicherweise kann es vorgesehen sein, dass die Vorrichtung zum Züchten synthetischer Diamanten eingesetzt wird.

Die Erfindung wird nun anhand von in den Zeichnungen dargestellten Ausführungsbeispielen näher erläutert.

Es zeigen:
- Fig. 1: ein erstes Ausführungsbeispiel der Erfindung in einem Vertikalschnitt,
- Fig. 2: ein zweites Ausführungsbeispiel der Erfindung in einem Vertikalschnitt,
- Fig. 3: eine perspektivische Ansicht des unteren schalenförmigen Halbkörpers,
- Fig. 4: eine perspektivische Ansicht des zweiteiligen Verschlusses,
- Fig. 5: eine perspektivische Ansicht eines Vertikalschnitts der Halbkörper und des Verschlusses im geschlossenen Zustand,
- Fig. 6: eine Detailansicht der Hochdruckrohrleitung beziehungsweise der Ölleitung in Form einer Schraubenfeder und des Gelenks im Bereich der Verbindung des unteren Halbkörpers und des oberen Halbkörpers und
- Fig. 7: die als Ölbypass zwischen den Halbkörpern dienende Ölleitung in Form einer Spirale zeigende, teils geschnittene Ansichten des unteren Halbkörpers und des oberen Halbkörpers der Vorrichtung,
- Fig. 7a: in einer teils geschnittenen Seitenansicht in geschlossenem Zustand,
- Fig. 7b: in einer teils geschnittenen Seitenansicht in geöffnetem, aufgeklapptem Zustand,

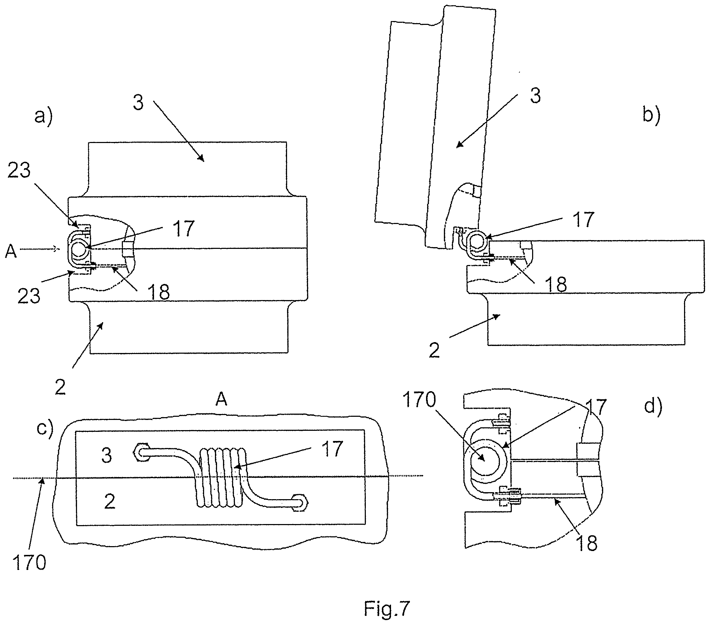

- Fig. 7 c: in einer Draufsicht auf den Bereich der Verbindung des unteren Halbkörpers und des oberen Halbkörpers in geschlossenem Zustand und
- Fig. 7 d: in einer teils geschnittenen Seitenansicht des Bereichs der Verbindung des unteren Halbkörpers und des oberen Halbkörpers.

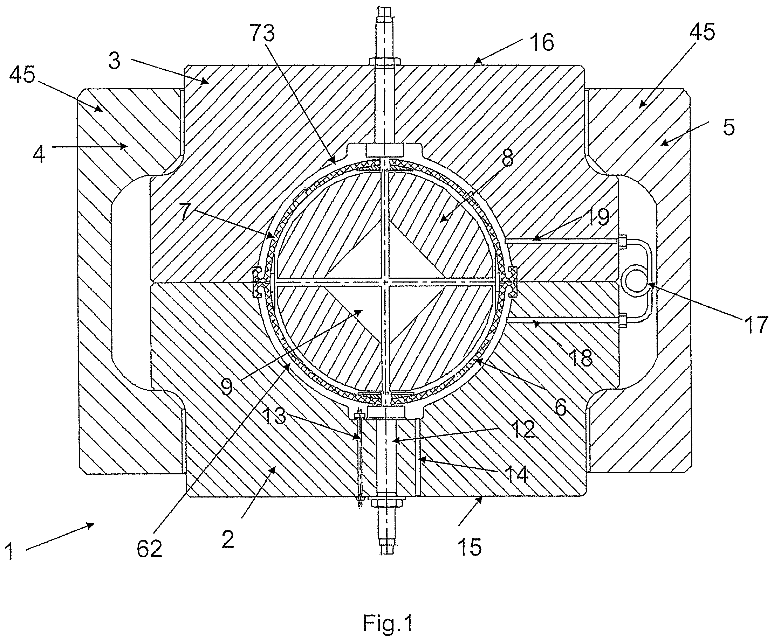

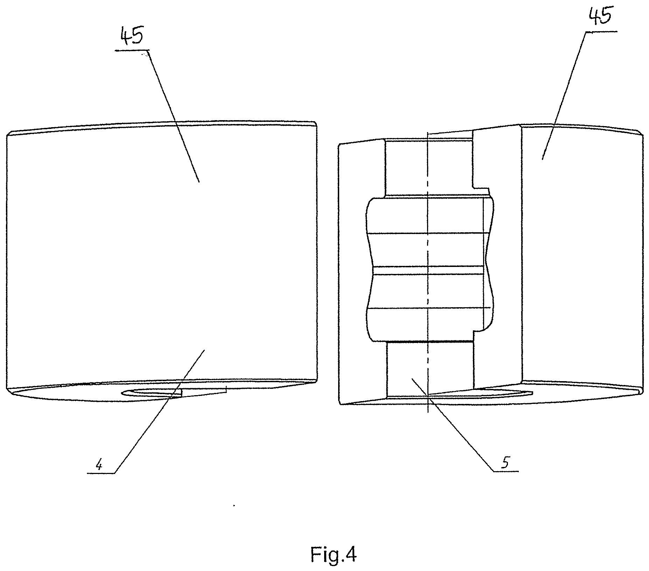

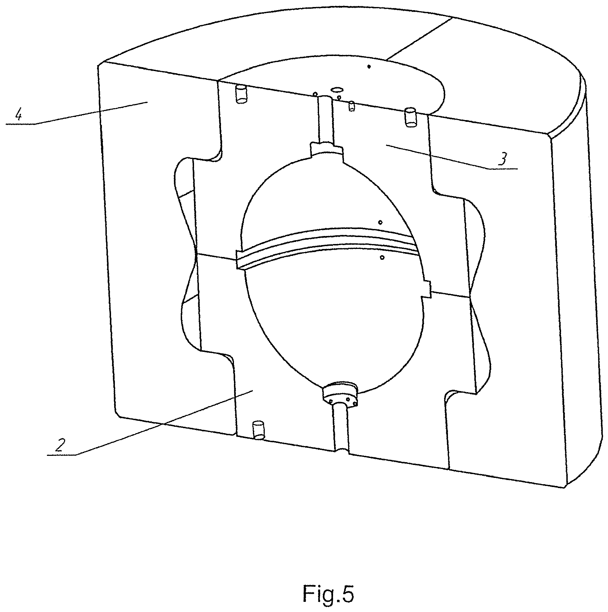

Eine in Fig. 1, Fig. 2, Fig. 3, Fig. 4, Fig. 5, Fig. 6 und in Fig. 7 ganz oder teilweise dargestellte erfindungsgemäße Vorrichtung 1 dient zur Erzeugung hoher Drücke in festen und flüssigen Medien. Die Vorrichtung 1 umfasst einen unteren schalenförmigen Halbkörper 2 und einen oberen schalenförmigen Halbkörper 3. Die Vorrichtung 1 umfasst außerdem eine untere elastische Membran 6 und eine obere elastische Membran 7, die jeweils in den unteren Halbkörper 2 und in den oberen Halbkörper 3 eingesetzt sind. Dabei umgeben der jeweilige Halbkörper 2, 3 und die jeweils in ihn eingesetzte Membran 6, 7 jeweils einen Druckraum 62, 73. Die Vorrichtung 1 umfasst darüber hinaus eine Öffnung und einen Kanal 14 im unteren Halbkörper 2, um eine Ölleitung von einer Ölpumpe an die Vorrichtung anzuschließen und das Öl in den Druckraum zwischen dem unteren Halbkörper 2 und der in ihn eingesetzten elastischen Membran 6 zu fördern. Die Druckräume 62, 73 im unteren Halbkörper 2 und im oberen Halbkörper 3 sind mittels einer Leitung verbunden. Die Vorrichtung 1 zeichnet sich dadurch aus, dass die Leitung die Druckräume 62, 73 im unteren Halbkörper 2 und im oberen Halbkörper 3 sowohl in geöffnetem als auch in geschlossenem Zustand der Vorrichtung permanent miteinander verbindet. Ferner zeichnet sich die Vorrichtung dadurch aus, dass sie eine außerhalb des unteren schalenförmigen Halbkörpers 2 und des oberen schalenförmigen Halbkörpers 3 verlaufende Rohrleitung umfasst, die in Form einer Schraubenfederleitung 17 ausgebildet ist.

Die Leitung umfasst vorteilhaft einen Verbindungsleitungsabschnitt 18 und einen Verbindungsleitungsabschnitt 18. Die beiden Verbindungsleitungsabschnitte 18, 19 sind mittels der Schraubenfederleitung 17 miteinander verbunden. Der Verbindungsleitungsabschnitt 18 führt dabei von dem Druckraum 62 zwischen der sphärischen Oberfläche des unteren Halbkörpers 2 und der in den unteren Halbkörper 2 eingesetzten elastischen Membran 6 durch den unteren Halbkörper 2 hindurch nach außen. An die äußere Mündung des Verbindungsleitungsabschnitts 18 ist die Schraubenfederleitung 17 mit ihrem einen Ende angeschlossen. Nach innen hin mündet der Verbindungsleitungsabschnitt 18 in den Druckraum 62. Der Verbindungsleitungsabschnitt 19 führt von dem Druckraum 73 zwischen der sphärischen Oberfläche des oberen Halbkörpers 3 und der in den oberen Halbkörper 3 eingesetzten elastischen Membran 7 durch den oberen Halbkörper 3 hindurch nach außen. An die äußere Mündung des Verbindungsleitungsabschnitts 19 ist die Schraubenfederleitung 17 mit ihrem verbleibenden Ende angeschlossen. Nach innen hin mündet der Verbindungsleitungsabschnitt 19 in den Druckraum 73.

Der Kanal 14 sowie die Verbindungsleitungsabschnitte 18 und 19 sind beispielsweise durch Bohrungen gebildete Öffnungen in den auch als Halbschalen bezeichenbaren Halbkörpern 2, 3, die als Kanäle für das Öl dienen. Die Verbindungsleitungsabschnitte 18 und 19 sind hierbei Abschnitte der die Druckräume 62, 73 im unteren Halbkörper 2 und im oberen Halbkörper 3 sowohl in geöffnetem, als auch in geschlossenem Zustand der Vorrichtung 1 permanent miteinander verbindenden Leitung. Der Kanal 14 bildet den von dem Druckraum 62 zwischen der sphärischen Oberfläche des unteren Halbkörpers 2 und der in den unteren Halbkörper 2 eingesetzten elastischen Membran 6 durch den unteren Halbkörper 2 hindurch nach außen führenden Abschnitt der den Druckraum 62 im unteren Halbkörper 2 mit der Ölpumpe verbindenden Ölleitung.

Demnach bilden der Kanal 14 sowie die Verbindungsleitungsabschnitte 18 und 19 Abschnitte des gesamten, geschlossenen Ölleitungssystems der Vorrichtung 1.

Die Schraubenfederleitung 17 ist vorzugsweise durch ein in Form einer Schraubenfeder um eine Wickelachse gewundenes Metallrohr gebildet. Beim Material der Schraubenfederleitung 17 handelt es sich bevorzugt um hochfesten Stahl oder dergleichen. Aufgrund dieser Form verhält sich das Metallrohr wie eine Feder, wenn der obere Halbkörper 3 der Vorrichtung 1 vom unteren Halbkörper 2 vorzugsweise um die Wickelachse weggeklappt wird. Durch diesen Wegklappen und wieder aufeinanderklappen öffnet und schließt sich die Vorrichtung 1. Die beispielsweise durch ein Metallrohr gebildete Schraubenfederleitung 17 ist an den äußeren Mündungen der durch Löcher im unteren und im oberen Halbkörper 2, 3 gebildeten Verbindungsleitungsabschnitten 18 und 19 befestigt. Das Verbindungsverfahren wird an dieser Stelle nicht diskutiert, erwähnt sei beispielsweise eine Gewindeverbindung, wie sie zur Verbindung von Hochdruckleitungen eingesetzt werden kann. Die Schraubenfederleitung 17 erfüllt auch die Funktion der kurz auch als Ölkanal bezeichenbaren, die Druckräume 62, 73 im unteren Halbkörper 2 und im oberen Halbkörper 3 sowohl in geöffnetem, als auch in geschlossenem Zustand der Vorrichtung 1 permanent miteinander verbindenden Leitung. Dabei ist die Schraubenfederleitung 17 ein Abschnitt oder ein Teil des Ölkanals.

Wenn Druck ausgeübt wird, wird Öl von einer Ölpumpe durch ein in den Kanal 14 mündendes, nicht dargestelltes Hochdruckrohr zugeführt. Das Hochdruckrohr ist mit dem Boden des durch ein Loch gebildeten Kanals 14 in der unteren Hälfte des durch den unteren und den oberen Halbkörper 2, 3 gebildeten Gehäuses verbunden. Das Öl tritt durch den Kanal 14 in den Druckraum 62 zwischen dem unteren Halbkörper 2 und der flexiblen Membran 6 ein. Aus diesem Druckraum 62 fließt das Öl durch den Verbindungsleitungsabschnitt 18 in die Schraubenfederleitung 17, dann in den Verbindungsleitungsabschnitt 19 und dann in den zwischen dem oberen Halbkörper 3 und der elastischen Membran 7 gebildeten Druckraum 73. Somit wird zu jedem Zeitpunkt ein gleicher Öldruck in den Druckräumen 62 und 73 erzeugt. In ähnlicher Weise verlässt das Öl die Druckräume 62, 73, wenn der Druck verringert wird, aber in die entgegengesetzte Richtung.

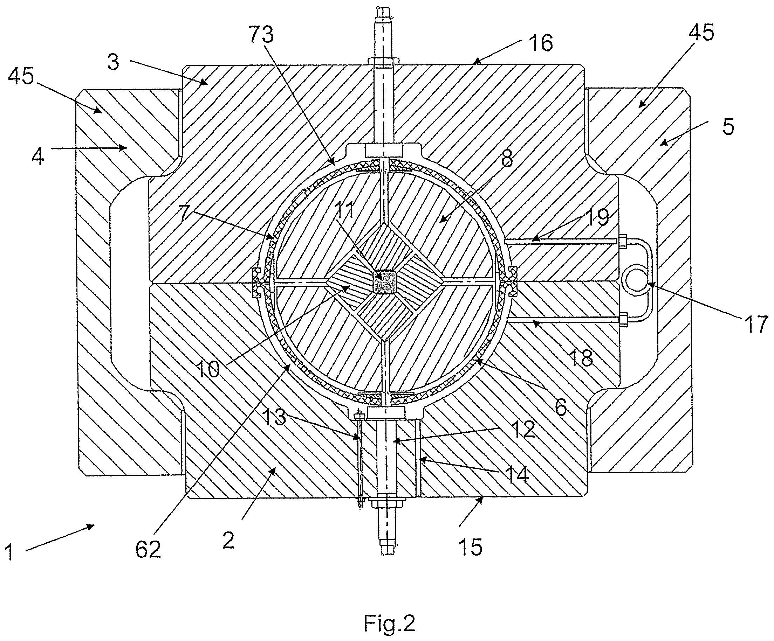

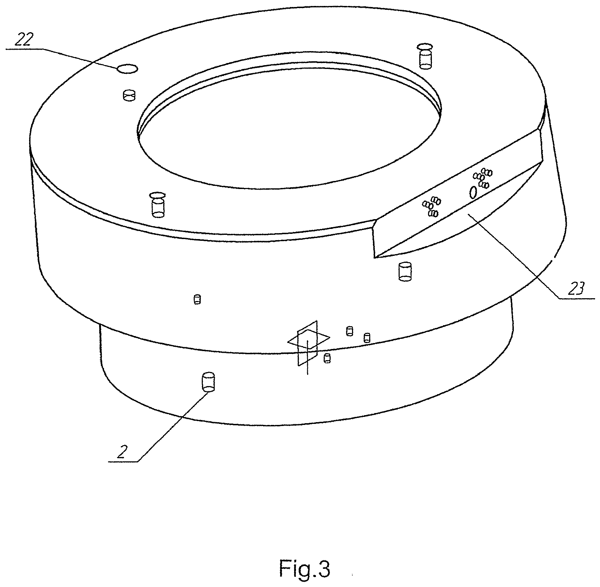

Die in den Fig. 1 und 2 dargestellte Vorrichtung 1 ist hier nur beispielhaft angegeben, damit erkennbar ist, wie die Erfindung eingesetzt werden kann. Die Vorrichtung 1 weist folgende Elemente auf:
- einen unteren schalenförmigen Halbkörper 2 (s. Fig. 3) und einen diesem ähnlichen oberen schalenförmigen Halbkörper 3,
- zwei gegenüberliegende Teile 4, 5 eines Verschlusses 45, welche die Halbkörper 2, 3 aneinanderdrücken,
- zwei elastische Membranen 6 und 7, die in die Kugelräume jedes der schalenförmigen Halbkörper 2, 3 eingesetzt sind und/oder werden und/oder einsetzbar sind; der jeweilige Halbkörper 2, 3 und die jeweils in ihn eingesetzte Membran 6, 7 umgeben jeweils einen Druckraum 62, 73,
- eine Spaltkugel aus vorzugsweise acht jeweils Stempel bildende, kurz als Kugelsektoren 8 bezeichnete, nach innen zum Zentrum der Kugel hin abgestumpfte beziehungsweise abgeschnittene Kugelausschnitt- oder Kugelsektorstümpfe, die in die Halbschale des unteren Halbkörpers 2 mit einer elastischen Membran 6 eingesetzt wird. Die vorzugsweise acht jeweils Stempel bildenden, kurz als Kugelsektoren 8 bezeichneten, nach innen zum Zentrum der Kugel hin abgestumpften beziehungsweise abgeschnittenen Kugelausschnitt- oder Kugelsektorstümpfe der Spaltkugel umgeben einen Hohlraum 9, der eine der Synthese dienende Zuchtkammer 11 beherbergt. Die durch die Kugelsektoren 8 gebildeten Stempel sind zum Hohlraum 9 hin kegel- und/oder pyramidenstumpfförmig. Im in Fig. 1 gezeigten Ausführungsbeispiel wirken die durch die acht Kugelsektoren 8 gebildeten Stempel direkt auf die in den oktaedrischen Hohlraum 9 gesetzte zentrale Zuchtkammer 11 ein,
- gemäß des in Fig. 2 gezeigten Ausführungsbeispiels befindet sich zwischen den beispielsweise acht den Hohlraum 9 umgebenden Kugelsektoren 8 der Spaltkugel und der Zuchtkammer 11 eine zweite Stufe von Kugelsektoren 10. Diese umgeben nach innen zum Zentrum der Kugel hin einen die Zuchtkammer beherbergenden und/oder bildenden, beispielsweise kubischen, Raum oder einen Raum in Form eines Quaders. Demnach wird bei dem in Fig. 2 dargestellten Ausführungsbeispiel anstelle der Zuchtkammer 11 unmittelbar eine zweite Stufe von ebenfalls kurz als Kugelsektoren 10 bezeichneten, nach innen zum Zentrum der Kugel hin abgestumpften beziehungsweise abgeschnittenen Kugelausschnitt- oder Kugelsektorstümpfen im beispielsweise oktaedrischen, vorzugsweise durch acht Kugelsektoren 8 der Spaltkugel erzeugten Hohlraum 9 angeordnet. Die zweite Stufe besteht bevorzugt aus sechs oktaedrischen pyramidalen Kugelsektoren 10. In diesem Fall wird die der Synthese dienende Zuchtkammer 11 in einen kubischen Raum oder in einen Raum in Form eines Quaders eingesetzt, der durch abgestumpfte Flächen der zweiten Stufe der oktaedrischen Kugelsektoren 10 erzeugt ist.

Die Vorrichtung 1 aus Fig. 1 enthält einen unteren schalenförmigen Halbkörper 2 und einen oberen schalenförmigen Halbkörper 3, einen speziellen Verschluss 45, zwei elastische Membranen 6, 7 und eine zwischen die Halbschalen mit elastischen Membranen einsetzbare Spaltkugel. Der Verschluss 45 besteht aus zwei Teilen 4, 5 und verhindert es, dass die Halbkörper 2, 3 beim Öldruckaufbau auseinandergehen. Elastische Membranen 6, 7 werden in die Kugelräume jedes der schalenförmigen Halbkörper 2, 3 eingesetzt.

Der untere Halbkörper 2 und die in ihn eingesetzte Membran 6 umschließen einen zwischen ihnen verbleibenden Druckraum 62. Ebenso umschließt der obere Halbkörper 3 und die in ihn eingesetzte Membran 7 einen Druckraum 73. Mit anderen Worten, der jeweilige Halbkörper 2, 3 und die jeweils in ihn eingesetzte Membran 6, 7 umgeben jeweils einen Druckraum 62, 73.

Die Spaltkugel besteht aus acht Kugelsektoren 8, die auf eine zentrale Zuchtkammer einwirken, die in einen oktaedrischen Hohlraum 9 gesetzt wird.

Eine weitere Ausgestaltung ist in Fig. 2 dargestellt. Anstelle der Zuchtkammer 11 kann eine zweite Stufe oktaedrischer pyramidaler Kugelsektoren 10 im oktaedrischen Hohlraum 9 platziert werden, der durch acht Kugelsektoren 8 der Spaltkugel erzeugt ist. In diesem Fall wird die Zuchtkammer 11 in einen kubischen Hohlraum oder einen Raum in Form eines Quaders 11 eingebracht, der durch die zweite Stufe der oktaedrischen Kugelsektoren 10 erzeugt ist. Somit wird durch die Reduzierung der Oberfläche eine erhebliche Druckverstärkung auf die in der Zuchtkammer 11 befindliche Rohmischung für die Diamantzüchtung oder Herstellung von anderen Kristallen und Sinterung von metallenen, keramischen Diamantpulvern und Nanopulvern ausgeübt.

Um elektrischen Strom zur Erwärmung der Rohmischung und Wasser zur Abkühlung der Kugelsektoren zuzuführen, können metallene Stromanschlüsse (Leistungseinführungen) 12 in den Halbkörpern 2, 3 eingebaut sein. Die Stromanschlüsse sind von den metallenen Halbkörpern 2, 3 isoliert. Eine Zentralöffnung ist vorgesehen, um das Wasser durchzulassen. Außerdem sind Messstromanschlüsse 13 in der Vorrichtung 1 vorgesehen, um die Signale der in der Vorrichtung 1 eingebauten Temperaturfühler und Druckgeber zu übertragen.

Der Druck in der Zuchtkammer 11 wird dadurch erzeugt, dass der Druck des den Druckräumen 62, 73 zwischen den Halbkörpern 2, 3 und den elastischen Membranen 6, 7 zugeführten Öls über die Membranen auf Kugelsektoren 8 der Spaltkugel übertragen wird, die dann diesen Druck auf die Zuchtkammer 11 übertragen. Bei einer anderen Ausgestaltung nach Fig. 2 übertragen die Kugelsektoren 8 der Spaltkugel den Druck auf die kleineren oktaedrischen Kugelsektoren 10 der zweiten Stufe. Die kleineren Kugelsektoren 10 übertragen dann den Druck in die Zuchtkammer 11. Die Bewegung der Kugelsektoren 8, 10 wird durch den Öldruck ausgelöst, der über die elastische Membran 6, 7 übertragen wird. Während des Betriebs erfolgt eine symmetrische und gleichzeitige Bewegung der Kugelsektoren 8 zum Mittelpunkt der Spaltkugel hin. Dafür muss eine Hochdruck-Ölpumpe das Öl mit gleichem Durchsatz gleichzeitig in den unteren 2 und in den oberen Halbkörper 3 der Vorrichtung 1 fördern. Darüber hinaus muss das Öl beim Druckabbau aus den beiden Halbkörpern 2, 3 mit gleichem Durchsatz austreten. Das heißt, der Öldruck in den Druckräumen 62, 73 im oberen 3 und im unteren Halbkörper 2 soll zu jedem Zeitpunkt sowohl beim Druckaufbau als auch beim Druckabbau gleich sein.

Bei manchen im Stand der Technik beschriebenen Vorrichtungen wird das Öl von der Hochdruckpumpe in den unteren Halbkörper über eine Ölleitung und in den oberen Halbkörper über eine andere Ölleitung gefördert. Aus den Fig. 1 und 2 geht eine Öffnung im unteren Halbkörper 2 hervor, die mit einer Rohrleitung der Ölleitung verbunden ist. Eine ähnliche Öffnung (auf den Figuren nicht abgebildet) kann auch im oberen Halbkörper vorhanden sein. Gemäß den bekannten Vorrichtungen wird die zweite Rohrleitung der Ölleitung an diese Öffnung angeschlossen. Diese Ölleitung ist mit der Pumpe verbunden. Während des Betriebs kann der Öldruck 250 MPa (2500 atm) erreichen. Daher werden Hochdruckrohrleitungen und Hochdruckverbindungen für Ölleitungen eingesetzt. Die Hochdruckrohrleitung und die Hochdruckverbindungen können eventuell während des Betriebs eine Gefährdung bei hohen Drücken herbeiführen, wenn die Rohrleitung bricht oder sich vom Halbkörper ablöst. Die geschlossene Vorrichtung und der versetzte Verschluss auf dem unteren Halbkörper 2 hat nur eine freie Oberfläche 15 unten, um die Hochdruck-Ölleitung anzuschließen. Auf dem oberen Halbkörper 3 gibt es ebenfalls eine freie Oberfläche 16 oben. Bei der von der Pumpe an die untere Oberfläche 15 des unteren Halbkörpers laufenden Hochdruck-Ölleitung handelt es sich um eine relativ kurze Hochdruckrohrleitung. Diese Hochdruckrohrleitung ist unter der Vorrichtung verdeckt und führt keine Gefährdung herbei, wenn die Rohrleitung bricht oder sich bei hohem Öldruck ablöst.

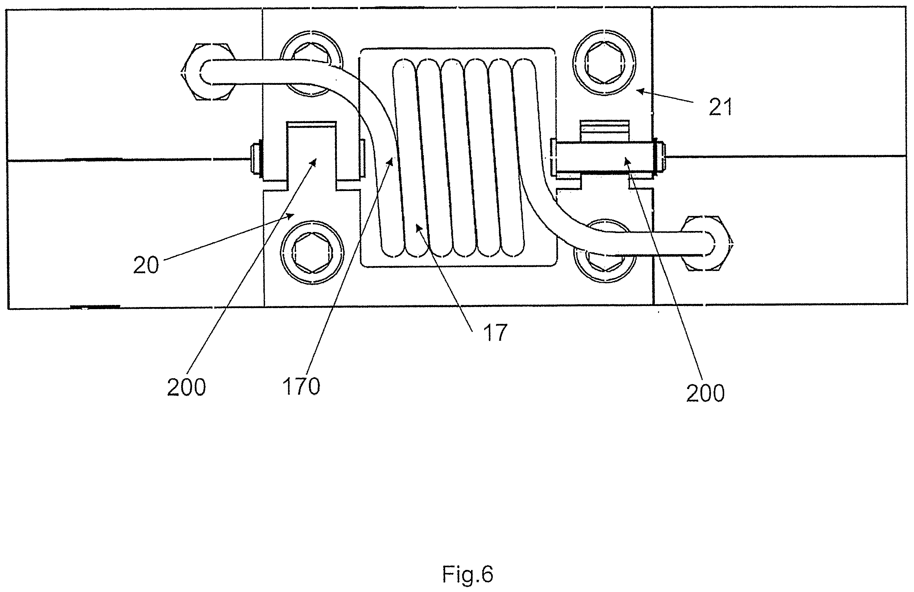

Bei der von der Pumpe an die obere Oberfläche 16 des oberen Halbkörpers laufenden Hochdruck-Ölleitung handelt es sich um eine beachtlich längere Hochdruckrohrleitung. Diese Rohrleitung ist an der Außenseite der Vorrichtung verlegt. Bei hohem Öldruck kann diese längere Rohrleitung eine Gefährdung herbeiführen, wenn sie eventuell bricht oder sich ablöst. Neben diesem Mangel sollte die Hochdruckrohrleitung, die die Pumpe mit der oberen Oberfläche 16 des oberen Halbkörpers verbindet, lang genug sein, um die Vorrichtung öffnen und schließen zu können. Der obere Halbkörper 3 und der untere Halbkörper 2 sind mittels eines Gelenks miteinander verbunden, das in Fig. 6 anhand der Gelenkverbindungen 20, 21 dargestellt ist. Das Gelenk sorgt dafür, dass die Vorrichtung sich öffnen und schließen lässt, und zwar dadurch, dass der obere Halbkörper 3 am Gelenk hoch- und zugeklappt wird. Die an den oberen Halbkörper 3 anschließbare Rohrleitung muss die Bewegungsmöglichkeit des oberen Halbkörpers 3 beim Öffnen und Schließen der Vorrichtung 1 ermöglichen. Um eine solche Bewegung ausführen zu können, muss die Rohrleitung eine ausreichende Länge haben, die einen benötigten Biegegrad sicherstellt, um den oberen Halbkörper 3 (Deckel) der Vorrichtung am Gelenk hoch- und zuzuklappen. Der Biegegrad der Hochdruckrohrleitung darf eine Größe nicht überschreiten, die sowohl bei der Bewegung des oberen Halbkörpers 3 als auch beim Hochdruckbetrieb höhere Spannungen in der Hochdruckrohrleitung und in den Hochdruckverbindungen hervorruft, als es zulässig ist.

Somit schafft die Anwendung der zusätzlichen die Hochdruckpumpe und den oberen Halbkörper verbindenden Ölleitung eine Gefährdung, wenn die Hochdruckrohrleitung bricht oder sich ablöst. Darüber hinaus macht der Einsatz der langen Hochdruckrohrleitung die Wartung weniger bequem und benachteiligt die Optik der Vorrichtung.

Gemäß der anderen bekannten Ausgestaltung ist ein spezielles Bypassventil zwischen dem unteren Halbkörper 2 und dem oberen Halbkörper 3 vorgesehen, um eine gleichzeitige Ölförderung von der Pumpe zu den beiden Halbkörpern und den Druckaufbau in der Vorrichtung sicherzustellen. Das Bypassventil wird in die Öffnungen 22 eingebaut. Die Öffnungen befinden sich auf den zusammenpassenden Oberflächen des unteren Halbkörpers und des oberen Halbkörpers (Fig. 3), wo sich der untere und der obere Teil des Bypassventils befinden. Wenn die Vorrichtung zugeklappt ist (Fig. 1, 2, 5), ist das Bypassventil geöffnet. Wird die Vorrichtung geöffnet, schließt das Bypassventil, damit das Öl aus den beiden Halbkörpern im geöffneten Zustand nicht hinausfließt. Beim Druckaufbau fließt das Öl aus dem unteren Halbkörper 2 in den oberen Halbkörper 3 oder beim Druckabbau umgekehrt aus dem oberen Halbkörper 3 in den unteren Halbkörper 2. Die offensichtlichen Vorteile dieser Konstruktion sind ihre Sicherheit, Betriebsfreundlichkeit der Vorrichtung und eine bessere Optik. Die Vorrichtung weist den Mangel auf, dass ein solches Bypassventil bewegliche Teile enthält, die beim Hochdruck arbeiten. Das führt zum Verschleiß dieser Teile. Folglich kann das Ventil keine vollständige Abdichtung sicherstellen. Das verursacht Öllecken sowohl unter Druck als auch beim Öffnen der Vorrichtung und zieht ständige Wartungsarbeiten sowie periodisches Austauschen der Ventilteile nach sich.

Um alle genannten Mängel der bekannten Konstruktionen der Vorrichtung zu beseitigen, wird gemäß der vorliegenden Erfindung eine neue Konstruktion für die Ölzuführung in den oberen Halbkörper 3 vorgeschlagen, um den Druck in der Vorrichtung 1 zu erzeugen.

Um zu vermeiden, dass
- eine zusätzliche Ölleitung eingesetzt werden muss, die die Hochdruckpumpe mit dem oberen Halbkörper verbindet, und
- ein Hochdruck-Bypassventil zwischen den Halbkörpern eingesetzt werden muss,
wird erfindungsgemäß vorgeschlagen, den benötigten Ölbypass zwischen den Halbkörpern 2, 3 mit Hilfe einer speziellen Ölleitung auszuführen, die den Druckraum 62 im unteren Halbkörper 2 und den Druckraum 73 im oberen Halbkörper 3 der Vorrichtung 1 permanent verbindet.

Die vorgeschlagene Ölleitung ist an den unteren Halbkörper 2 und an den oberen Halbkörper 3 fest angeschlossen. Vorzugsweise kann sie das Öl unter einem Druck von mindestens 2,500 bar umleiten. Dabei muss die Bypass-Ölleitung möglichst kurz sein und einen ziemlich großen inneren Querschnitt haben, um einen gleichen Öldruck gleichzeitig in beiden Halbkörpern beim Druckaufbau und beim Druckabbau sicherzustellen. Die Bypass-Ölleitung muss auch in der Konstruktion der Vorrichtung 1 verdeckt sein, um die Sicherheit beim Betrieb unter Druck sicherzustellen, keine Hindernisse beim Betrieb der Anlage zu bereiten, die Bewegung des oberen Halbkörpers 3 am Gelenk 20, 21 zu ermöglichen, so dass die Vorrichtung 1 geöffnet und geschlossen werden kann, und um die Optik der Vorrichtung 1 nicht zu beeinträchtigen.

Um die oben genannten Voraussetzungen zu erfüllen, wird vorgeschlagen, die Ölleitung in Form einer Schraubenfeder im Bereich der Gelenkverbindung der Halbkörper 2, 3 auszubilden. Während des Betriebs wird das Öl in den unteren Halbkörper 2 gefördert und fließt von dort über die Schraubenfederleitung 17 in den oberen Halbkörper 3. Wird die Vorrichtung 1 geöffnet und geschlossen, wird die Schraubenfederleitung 17 als Feder auf Verdrillung beansprucht, wodurch ermöglicht wird, dass sich der obere Halbkörper 3 bei Bedarf bewegen kann.

Erfindungsgemäß ist demnach vorgesehen, dass die Druckräume 62, 73 im unteren Halbkörper 2 und im oberen Halbkörper 3 mittels einer Rohrleitung permanent, das heißt sowohl in geschlossenem als auch in geöffnetem Zustand der Vorrichtung 1 miteinander verbunden sind, die in Form einer Schraubenfederleitung 17 ausgebildet ist.

Über die Rohrleitung steht der Druckraum 62 im unteren Halbkörper 2 und der Druckraum 73 im oberen Halbkörper in permanentem Austausch. Über die Rohrleitung kommunizieren der Druckraum 62 im unteren Halbkörper 2 und der Druckraum 73 im oberen Halbkörper 3 permanent miteinander.

Indem die Rohrleitung die Druckräume 62, 73 im unteren Halbkörper 2 und im oberen Halbkörper 3 permanent miteinander verbindet, wird das Austreten von Öl beim Umgang mit der Vorrichtung 1, insbesondere bei deren Öffnen, verhindert. Darüber hinaus schafft die die Druckräume 62, 73 im unteren Halbkörper 2 und im oberen Halbkörper 3 permanent miteinander verbindende Rohrleitung die Voraussetzung dafür, dass die Druckräume 62, 73 im unteren Halbkörper 2 und im oberen Halbkörper 3 ventilfrei miteinander verbunden sein können.

Die Rohrleitung ist besonders vorteilhaft ventilfrei ausgeführt. Demnach befindet sich kein Ventil zwischen den Druckräumen 62, 73 im unteren Halbkörper 2 und im oberen Halbkörper 3 entlang der Rohrleitung gesehen.

Die Ventilfreiheit stellt sicher, dass während des Druckaufbaus, des Druckhaltens, und während des Druckabbaus keine Druckunterschiede zwischen den Druckräumen 62, 73 im unteren Halbkörper 2 und im oberen Halbkörper 3 auftreten können. Hierdurch wird gewährleistet, dass die Stempel bildenden Kugelsektoren einer Spaltkugel während des Druckaufbaus und während des Druckabbaus alle synchron eine symmetrische Bewegung ausführen. Die Spaltkugel ist in die Halbkörper 2, 3 mit den elastischen Membranen 6, 7 einsetzbar. Die Kugelsektoren bilden einen Hohlraum, der die Zuchtkammer beherbergt. Indem sichergestellt ist, dass die Kugelsektoren alle zeitgleich eine symmetrische Bewegung ausführen, kommt es zu keinerlei Schiefstellung zwischen ihnen. Hierdurch kommt es im Vergleich zum Stand der Technik zu keinem Bruch der inneren Stempel und damit zu keinerlei Materialausbruch in der Zuchtkammer. Dies verringert die Ausschussquote des in der Zuchtkammer erzeugten, als Syntheseergebnis bezeichneten Syntheseerzeugnisses, einhergehend mit einer Qualitätssteigerung des Syntheseergebnisses. Hierdurch wird sichergestellt, dass mittels der Vorrichtung Syntheseergebnisse gleichbleibender homogener hoher Qualität hergestellt werden können.

Damit die Rohrleitung der Relativdrehbewegung zwischen dem unteren Halbkörper 2 und dem oberen Halbkörper 3 beim Öffnen und Schließen der Vorrichtung 1 folgen kann, ist sie in Form einer Schraubenfederleitung 17 ausgebildet. Hierdurch kann sie ohne bewegliche Teile ausgeführt werden. Zusammen mit der Ventilfreiheit ist hierdurch sichergestellt, dass es unter den zur Herstellung eines Syntheseergebnisses notwendigen hohen Drücken zu keinem erhöhten Verschleiß beweglicher Teile entlang der Ölleitung zwischen den beiden Druckräumen 62, 73 kommen kann. Das Auftreten eines solchen Verschleißes beweglicher Teile würde den Druckausgleich zwischen den Druckräumen 62, 73 im unteren und im oberen Halbkörper 2, 3 beeinträchtigen oder gar vollständig behindern. Durch den Verzicht auf bewegliche Teile werden die die Qualität des Syntheseergebnisses nachteilig beeinträchtigenden Störungen eines gleichmäßigen Druckauf- und -abbaus in den Druckräumen 62, 73 im unteren und im oberen Halbkörper 2, 3 ausgeschlossen.

Eine Wickelachse der Schraubenfederleitung liegt hierbei vorteilhaft innerhalb einer gemeinsamen Teilungsebene zwischen den beiden Halbkörpern 2, 3. Die gemeinsame Teilungsebene wird durch diejenige Fläche aufgespannt, an der die beiden Halbkörper 2, 3 bei geschlossener Vorrichtung 1 aneinander anliegen.

Die Rohrleitung ist bevorzugt Teil einer zusätzlich zwei Verbindungsleitungsabschnitte 18, 19 umfassenden Leitung. In jedem Halbkörper ist ein Verbindungsleitungsabschnitt 18, 19 ausgebildet. Die Verbindungsleitungsabschnitte 18, 19 können durch in den jeweiligen Druckraum 62, 73 führende Bohrungen in den Halbkörpern 2, 3 verwirklicht sein.

Die die Druckräume 62, 73 im unteren Halbkörper 2 und im oberen Halbkörper 3 miteinander verbindende, die beiden Verbindungsleitungsabschnitte 18, 19 und die Schraubenfederleitung 17 umfassende Leitung ist gemäß einer besonders vorteilhaften Ausgestaltung der Erfindung frei von Ventilen. Vorteilhaft ist sie außerdem frei von sonstigen beweglichen Teilen. Eine Torsion der mit ihren beiden Enden an die Mündungen der Verbindungsleitungen 18, 19 an den beiden Halbkörpern 2, 3 angeschlossene Schraubenfederleitung 17 stellt hierbei kein bewegliches Teil im Sinne der voranstehenden Bemerkung dar.

Die Verbindungsleitungsabschnitte 18, 19 verlaufen vorteilhaft parallel zueinander sowie parallel zu der gemeinsamen Teilungsebene. Sie treten vorteilhaft seitlich aus den Halbkörpern aus. Besonders bevorzugt treten sie auf derselben Seite seitlich aus den Halbkörpern aus, wo sie mit der Schraubenfederleitung miteinander verbunden sind.

Die Gelenkachse stimmt vorteilhaft mit der Wickelachse der Schraubenfederleitung überein.

Zusammengefasst sieht die Erfindung zur Lösung der gestellten Aufgabe vorteilhaft vor:
Die Ölleitung umfasst die Verbindungsleitungsabschnitte 18 und 19 sowie die Schraubenfederleitung 17.
Die Ölleitung verbindet die Druckräume 62, 73 permanent miteinander. Hierdurch stehen die Druckräume 62, 73 über die Ölleitung sowohl in geöffnetem als auch in geschlossenem Zustand der Vorrichtung 1 sowie in allen Zwischenstellungen in ununterbrochener Verbindung.
Die Ölleitung ist ventilfrei, das heißt ohne Ventile ausgeführt.
Die Ölleitung kommt ohne bewegliche Teile aus.
Die Schraubenfederleitung 17 wird beim Öffnen und Schließen der Vorrichtung 1 nur auf Torsion beansprucht, ist aber ansonsten unbewegt.
Die Verbindungsleitungsabschnitte 18, 19 verlaufen parallel zueinander sowie parallel zu einer gemeinsamen Teilungsebene zwischen dem unteren Halbkörper 2 und dem oberen Halbkörper 3.
Die Verbindungsleitungsabschnitte 18, 19 sind durch Bohrungen in dem unteren Halbkörper 2 und dem oberen Halbkörper 3 verwirklicht.
Die Verbindungsleitungsabschnitte 18, 19 treten auf derselben Seite seitlich aus dem unteren Halbkörper 2 und dem oberen Halbkörper 3 aus, wo sie jeweils mit der Schraubenfederleitung 17 und über die Schraubenfederleitung 17 miteinander verbunden sind.
Die Gelenkachse stimmt mit der Wickelachse der Schraubenfederleitung 17 überein. Bei der Gelenkachse kann es sich um eine Welle eines die beiden Halbkörper beweglich verbindenden Gelenks handeln.

Über eine vollständige Lösung der gestellten Aufgabe hinausgehende Vorteile gegenüber dem Stand der Technik sind:
Der Druckraum 62 zwischen der sphärischen Oberfläche des unteren Halbkörpers 2 und der in ihn eingesetzten elastischen Membran 6 und der Druckraum 73 zwischen der sphärischen Oberfläche des oberen Halbkörpers 3 und der in ihn eingesetzten elastischen Membran 7 sind über die Ölleitung permanent, das heißt sowohl in geöffnetem als auch in geschlossenem Zustand sowie in jeder Zwischenstellung der Vorrichtung 1, miteinander verbunden. Hierdurch kann beim Öffnen und Schließen der Vorrichtung 1 kein Öl austreten. Darüber hinaus kann hierdurch auf Ventile und zu deren Aufbau sowie Funktion beitragende bewegliche Teile verzichtet werden. Indem die Ölleitung eine Rohrleitung umfasst, die in Form einer Schraubenfederleitung 17 ausgeführt ist, kann die Ölleitung die Relativbewegung zwischen dem unteren Halbkörper 2 und dem oberen Halbkörper 3 beim Öffnen und Schließen der Vorrichtung 1 überbrücken, ohne dass hierfür bewegliche Teile erforderlich wären. Durch den vollständigen Verzicht auf bewegliche Teile wird eine Beeinträchtigung oder Behinderung eines Druckausgleichs zwischen den Druckräumen 62, 73 im unteren und im oberen Halbkörper 2, 3 ausgeschlossen. Hierdurch wird eine permanente Druckgleichheit in den Druckräumen 62, 73 im unteren und im oberen Halbkörper 2, 3 während des Druckaufbaus, des Druckhaltens und des Druckabbaus über den gesamten Syntheseprozess sichergestellt. Damit wird eine gleichbleibende Qualität des Syntheseergebnisses gewährleistet, da es zu keinen Schiefstellungen zwischen den einen die Zuchtkammer beherbergenden Hohlraum 9 umgebenden Kugelsektoren 8.

Durch bewegliche Teile hervorgerufene Druckunterschiede zwischen den Druckräumen 62, 73 führen zu unsymmetrischen Bewegungen der Stempel bildenden Kugelsektoren 8. Durch unsymmetrische Bewegungen kommt es zu Schiefstellungen zwischen den Kugelsektoren 8. Bereits sehr geringe Schiefstellungen führen bei dem zum Betrieb der Zuchtkammer notwendigen Hochdruck zu einem Bruch der internen Stempel und/oder zu einem Materialausbruch in der Zuchtkammer. Dies macht das in der Zuchtkammer erzeugte Syntheseergebnis unbrauchbar.

Die Vorrichtung 1 trägt damit zu einer Verringerung des Ausschusses bei der Herstellung von Syntheseerzeugnissen bei, einhergehend mit einer Kostensenkung bei der Herstellung. Die Kostensenkung ist bedingt durch die geringere Ausschussquote und durch einen einfacheren Umgang. Der einfachere Umgang hat eine höhere Taktung entsprechend einer höheren Anzahl von innerhalb einer vorgegebenen Zeitspanne herstellbarer Syntheseerzeugnisse zur Folge. Die höhere Taktung wird erreicht, da beim Öffnen und Schließen bei der Vorrichtung 1 im Vergleich zum Stand der Technik nicht auf das Austreten von Öl beziehungsweise Hydraulikflüssigkeit geachtet werden muss. Auf das Austreten von Öl beziehungsweise Hydraulikflüssigkeit muss deshalb nicht mehr geachtet werden, weil die Schraubenfederleitung 17 die Druckräume 62, 73 im oberen und im unteren Halbkörper 2, 3 permanent in geöffnetem und in geschlossenem Zustand der Vorrichtung 1 miteinander verbindet.

Die Vorrichtung 1 kann darüber hinaus umfassen:
- metallene Stromanschlüsse 12, die von den bevorzugt metallenen Halbkörpern elektrisch isoliert sind, mit einer Zentralöffnung, um das Wasser durchzulassen; die Stromanschlüsse speisen einen Heizkörper in der Zuchtkammer, um die Rohmischung zu erwärmen; das Wasser läuft durch die Öffnung in den Stromanschlüssen, um die Kugelsektoren abzukühlen;
- Messstromanschlüsse 13, um Signale von in der Vorrichtung 1 eingebauten Temperaturfühlern und Druckgebern zu übertragen.

Die Vorrichtung 1 arbeitet wie folgt:
Nach der Beschickung und dem Schließen der Vorrichtung 1 fördert die Hochdruckpumpe das Öl über eine Öffnung des Kanals 14 in den unteren Halbkörper 2. Das Öl fließt über den Kanal 14 in einen Druckraum 62 zwischen der sphärischen Oberfläche des unteren Halbkörpers 2 und der in ihn eingesetzten elastischen Membran 6. Der jeweilige Halbkörper 2, 3 und die jeweils in ihn eingesetzte Membran 6, 7 umgeben jeweils einen Druckraum 62, 73.

Der Druckraum 62 im unteren Halbkörper 2 ist mit dem Druckraum 73 im oberen Halbkörper 3 mittels einer Ölleitung verbunden.

Die Ölleitung verbindet die Druckräume 62, 73 im unteren Halbkörper 2 und im oberen Halbkörper 3 sowohl in geöffnetem als auch in geschlossenem Zustand der Vorrichtung 1 permanent miteinander. Die Ölleitung umfasst eine außerhalb des unteren schalenförmigen Halbkörpers 2 und des oberen schalenförmigen Halbkörpers 3 verlaufende Rohrleitung, die in Form einer Schraubenfederleitung 17 ausgebildet ist. Die kurz als Schraubenfederleitung 17 bezeichnete, als Ölleitung dienende Rohrleitung ist in Form einer sich entlang einer Wickelachse um diese windende Spirale ausgebildet. Die erfindungsgemäße Ausgestaltung der Schraubenfederleitung 17 ist in den Figuren 1 und 2 und noch ausführlicher in den Figuren 6 und 7 dargestellt. Vorteilhaft umfasst die Ölleitung außerdem eine bevorzugt durch eine Bohrung gebildete erste, von dem Druckraum 62 im unteren Halbkörper 2 durch den unteren Halbkörper 2 hindurch nach außen führende Verbindungsleitung 18. Darüber hinaus umfasst die Ölleitung vorteilhaft eine bevorzugt ebenfalls durch eine Bohrung gebildete zweite, von dem Druckraum 73 im oberen Halbkörper 3 durch den oberen Halbkörper 3 hindurch nach außen führende Verbindungsleitung 19.

Damit umfasst die Ölleitung vorteilhaft eine erste, durch den unteren Halbkörper 2 hindurchführende Verbindungsleitung 18 zwischen dem Druckraum 62 im unteren Halbkörper 2 und der Schraubenfederleitung 17 und eine zweite, durch den oberen Halbkörper 3 hindurchführende Verbindungsleitung 19 zwischen dem Druckraum 73 im oberen Halbkörper 3 und der Schraubenfederleitung 17.

Besonders vorteilhaft ist die die Druckräume 62, 73 im unteren Halbkörper 2 und im oberen Halbkörper 3 verbindende Leitung frei von Ventilen ausgeführt.

Die Verbindung der Druckräume 62, 73 im unteren Halbkörper 2 und im oberen Halbkörper 3 mittels der Rohrleitung ist frei von Ventilen gleich jeder Art, seien dies Rückströmventile oder Bypassventile oder Überdruckventile, um keine beweglichen Teile zu benötigen, die unter hohem Druck schnell verschleißen, einen gleichmäßigen und zeitgleichen Druckanstieg und -abbau in den Druckräumen 62, 73 im unteren Halbkörper 2 und im oberen Halbkörper 3 sicherzustellen.

Eine auch noch so kleine Zeitverschiebung beim Druckanstieg und -abbau zwischen den Druckräumen 62, 73 im unteren Halbkörper 2 und im oberen Halbkörper 3 führt zu einer ungleichmäßigen Verschiebung der Kugelsektoren 8. Sollen zur Erzeugung eines Syntheseergebnisses sehr hohe Drücke mit der Vorrichtung erreicht werden können, so sind solche ungleichmäßigen Verschiebungen zu unterbinden, da sie bei den herrschenden sehr hohen Drücken zu Verspannungen zwischen den Kugelsektoren 8 und schließlich zu deren Bruch führen.

Die Schraubenfederleitung 17 ist bevorzugt in einer gemeinsamen Ausnehmung 23 angeordnet und befestigt. Die gemeinsame Ausnehmung ist durch die Ausnehmungen 23 der zusammengepassten unteren und oberen Halbkörper 2, 3 (Figuren 3 und 7) gebildet. Das Gelenk 20, 21 (Figuren 6 und 7) ist in der gleichen Ausnehmung 23 angeordnet und befestigt. Das Gelenk 20, 21 ermöglicht es, die Vorrichtung 1 zu öffnen und zu schließen, indem das am Gelenk 20, 21 befestigte obere Gehäuse hoch- und zugeklappt wird.

Die Schraubenachse 170 der Schraubenfederleitung 17 stimmt bevorzugt mit der Gelenkachse 200 des Gelenks 20, 21 überein (Fig. 6, Fig. 7c, Fig. 7 d).

Die Fig. 7a zeigt die als Ölleitung zwischen den Druckräumen 62, 73 dienende Schraubenfederleitung 17 im geschlossenen Zustand der Anlage. Die Fig. 7b zeigt die Schraubenfederleitung 17 im geöffneten Zustand mit dem am Gelenk 20, 21 hochgeklappten Halbkörper. Die Schraubenfederleitung 17 wird auf Verdrillung beansprucht und stellt die erforderliche Bewegung des oberen Halbkörpers 3 gegenüber dem unteren Halbkörper 2 um die Gelenkachse 200 sicher. Die Ausnehmung 23 ermöglicht es, die Teile 4, 5 des Verschlusses 45 dicht an die geschlossenen Halbkörper 2, 3 zu verschieben und den unteren und den oberen Halbkörper 2, 3 beim Druckaufbau geschlossen festzuhalten.

Das in den Druckraum 62 zwischen der sphärischen Oberfläche des unteren Halbkörpers 2 und der elastischen Membran 6 kommende Öl fließt über die Schraubenfederleitung 17 in den Druckraum 73 zwischen der sphärischen Oberfläche des oberen Halbkörpers 3 und der elastischen Membran 7. Somit wird ein gleicher Öldruck sowohl im Druckraum 62 im unteren Halbkörper 2 als auch im Druckraum 73 im oberen Halbkörper 3 gleichzeitig erzeugt.

Der Öldruck des den Druckräumen 62 und 73 zwischen den Halbkörpern 2 und 3 und den elastischen Membranen 6 und 7 zugeführten Öls wird über die Membranen 6, 7 an die Kugelsektoren 8 der Spaltkugel übertragen. Die Kugelsektoren 8 verlagern sich gleichzeitig zum Mittelpunkt hin und erzeugen somit den Druck im die Zuchtkammer 11 beherbergenden Hohlraum 9 (Fig. 1).

Bei dem in Fig. 2 gezeigten Ausführungsbeispiel übertragen die Kugelsektoren 8 der Spaltkugel die Bewegung auf die kleineren oktaedrischen Kugelsektoren 10 der zweiten Stufe. Diese verlagern sich ihrerseits gleichzeitig zum Mittelpunkt der Kugel hin und erzeugen somit den Druck in der Zuchtkammer 11. Eine Fläche A1 der Außenfläche der unter Öldruck stehenden Spaltkugel ist beachtlich größer als eine Fläche A2 der Zuchtkammer 11. Dadurch überschreitet der Druck in Zuchtkammer 11 den Öldruck wesentlich, und zwar proportional zum Flächenverhältnis A2/A1.

Zu jedem Zeitpunkt während des Pumpenbetriebs entsteht immer der gleiche Öldruck in den Druckräumen 62, 73 im unteren und im oberen Halbkörper 2, 3. Folglich kommt eine symmetrische Bewegung der Kugelsektoren 8 zum Mittelpunkt der Spaltkugel zustande. Ähnlich gehen die Kugelsektoren 8 der Spaltkugel beim Öldruckabbau gleichzeitig, symmetrisch und mit gleicher Geschwindigkeit im unteren Halbkörper 2 und im oberen Halbkörper 3 auseinander. Eine solche gleichzeitige, symmetrische Bewegung der Kugelsektoren 8 schließt jegliche Versetzungen (Schrägstellungen) im System der Kugelsektoren 8 aus und sorgt für die störungsfreie Funktion der Vorrichtung 1.

Die Vorrichtung 1 macht es möglich, die für die Diamantsynthese erforderlichen Drücke in der Zuchtkammer 11 zu erzeugen.

Man erkennt, dass die Erfindung jedenfalls durch eine Vorrichtung 1 zur Erzeugung hoher Drücke in festen und flüssigen Medien, insbesondere zum Züchten eines synthetischen Diamanten, verwirklicht ist, welche aufweist:
- einen unteren schalenförmigen Halbkörper 2 und einen oberen schalenförmigen Halbkörper 3,
- zwei gegenüberliegende Teile 4, 5 des Verschlusses 45, die die Halbkörper 2, 3 aneinanderdrücken,
- eine untere elastische Membran 6 und eine obere elastische Membran 7, die jeweils in den unteren Halbkörper 2 und in den oberen Halbkörper 3 einsetzbar sind,
- eine in den unteren Halbkörper 2 mit der elastischen Membran 6 einsetzbare Spaltkugel, die aus acht Kugelabschnitten 8 besteht, deren abgestumpfte Spitzen einen oktaederförmigen Hohlraum 9 bilden,
- sechs im oktaedrischen Hohlraum 9 platzierbare Kugelabschnitte 10 in Form von abgestumpften oktaedrischen Pyramiden, deren abgestumpfte Spitzen einen Raum in Form von einem Kubus oder einem Quader bilden,
- eine Zuchtkammer 11, die im kubischen Raum angeordnet ist,
- Stromanschlüsse 12 zur Speisung des Heizkörpers in der Zuchtkammer,
- Messstromanschlüsse 13, um elektrische Signale der in der Vorrichtung eingebauten Temperaturfühler und Druckgeber zu übertragen,
- eine Öffnung und einen Kanal 14 im unteren Halbkörper 2, um eine Ölleitung von einer Ölpumpe an die Vorrichtung 1 anzuschließen und das Öl in den Druckraum 62 zwischen dem unteren Halbkörper 2 und der elastischen Membran 6 zu fördern,
- eine ähnliche Öffnung und einen Kanal im oberen Halbkörper 3, um die durch das Öl bei Erstölfüllung der Vorrichtung verdrängte Luft auszulassen,
- eine Ausnehmung 23 im unteren Halbkörper 2 und eine ähnliche Ausnehmung 23 im oberen Halbkörper 3 zur Aufnahme eines Gelenks 20, 21, das das Öffnen und das Schließen der Vorrichtung 1 sicherstellt, und
- ein Gelenk 20, 21, das an die Halbkörper 2, 3 in der Ausnehmung 23 angeschlossen wird.

Die Vorrichtung 1 zeichnet sich bevorzugt dadurch aus,
- dass der Druckraum 62 im unteren Halbkörper 2 und der Druckraum 73 im oberen Halbkörper 3 mittels einer Rohrleitung permanent miteinander verbunden sind, die einen Ölbypass zwischen den Druckräumen 62, 73 in den Halbkörpern 2, 3 sicherstellt und in Form einer Schraubenfederleitung 17 ausgebildet ist, und/oder
- dass die Schraubenfederleitung 17 auf Verdrillung und Rückverdrehung beansprucht wird, so dass der obere Halbkörper 3 am Gelenk 20, 21 hoch- und zugeklappt werden kann, und/oder
- dass jeder der Halbkörper 2, 3 je eine zusätzliche Öffnung und je einen durch den Verbindungsleitungsabschnitt 18 im unteren Halbkörper 2 und durch den Verbindungsleitungsabschnitt 19 im oberen Halbkörper 3 gebildeten Kanal aufweist, um die Schraubenfederleitung 17 anzuschließen und den Ölfluss zwischen der Schraubenfederleitung 17 und dem durch den unteren Halbkörper 2 und die elastische Membran 6 gebildeten Druckraum 62 und dem durch den oberen Halbkörper 3 und der elastischen Membran 7 gebildeten Druckraum 73 zu ermöglichen.

Die zusätzliche Öffnung wird dabei durch die Mündungen der Verbindungsleitungsabschnitte 18, 19 gebildet.

Die Erfindung bietet Mittel, um den benötigten Druck zu erzeugen, damit superharte Stoffe synthetisiert sowie Pulver und Nanopulver unter Hochdruck gesintert werden können. Die Vorrichtung 1 ermöglicht es insbesondere, Hochdrücke zu erzeugen und Erwärmung anzuwenden, die dafür ausreichen, Diamanten und andere superharte Stoffe zu synthetisieren und Pulver, darunter auch Diamantpulver, zu sintern.

### Bezugszeichenliste

- 1: Vorrichtung
- 2: unterer Halbkörper
- 3: oberer Halbkörper
- 4: Teil des Verschlusses
- 5: Teil des Verschlusses
- 6: elastische Membran des unteren Halbkörpers
- 7: elastische Membran des oberen Halbkörpers
- 8: Kugelsektor der Spaltkugel
- 9: oktaedrischer Hohlraum für die Aufnahme der Zuchtkammer oder der zweiten Stufe der oktaedrischen Kugelsektoren
- 10: oktaedrischer Kugelsektor
- 11: Zuchtkammer
- 12: Stromanschluss
- 13: Messstromanschluss
- 14: Ölzuführungskanal für den unteren Halbkörper
- 15: Oberfläche des unteren Halbkörpers, frei für den Anschluss der externen Ölleitung
- 16: Oberfläche des oberen Halbkörpers, frei für den Anschluss der externen Ölleitung
- 17: Schraubenfederleitung: Rohrleitung in Form einer Schraubenfeder für den Ölbypass zwischen dem unteren und dem oberen Halbkörper
- 18: Verbindungsleitung zwischen dem unteren Halbkörper und der Schraubenfederleitung für den Ölbypass
- 19: Verbindungsleitung zwischen dem oberen Halbkörper und der Schraubenfederleitung für den Ölbypass
- 20: Gelenkverbindung zwischen dem unteren und dem oberen Halbkörper
- 21: Gelenkverbindung zwischen dem unteren und dem oberen Halbkörper
- 22: Öffnung für die Montage des Bypassventils in der Vorrichtung aus dem Stand der Technik
- 23: Ausnehmung für die Aufnahme des Gelenkes und der Schraubenfederleitung für den Ölbypass
- 45: Verschluss
- 62: Druckraum
- 73: Druckraum
- 170: Schraubenachse
- 200: Gelenkachse

## Patentansprüche

1. Vorrichtung (1) zur Erzeugung hoher Drücke in festen und flüssigen Medien, umfassend:
- einen unteren schalenförmigen Halbkörper (2) und einen oberen schalenförmigen Halbkörper (3),
- eine untere elastische Membran (6) und eine obere elastische Membran (7), die jeweils in den unteren Halbkörper (2) und in den oberen Halbkörper (3) eingesetzt sind, wobei der jeweilige Halbkörper (2, 3) und die jeweils in ihn eingesetzte Membran (6, 7) jeweils einen Druckraum (62, 73) umgeben,
- eine Öffnung und einen Kanal (14) im unteren Halbkörper (2), um eine Ölleitung von einer Ölpumpe an die Vorrichtung anzuschließen und das Öl in den Druckraum zwischen dem unteren Halbkörper (2) und der in ihn eingesetzten elastischen Membran (6) zu fördern,
wobei die Druckräume (62, 73) im unteren Halbkörper (2) und im oberen Halbkörper (3) mittels einer Leitung verbunden sind,
**dadurch gekennzeichnet,**
**dass** die Leitung die Druckräume (62, 73) im unteren Halbkörper (2) und im oberen Halbkörper (3) sowohl in geöffnetem als auch in geschlossenem Zustand der Vorrichtung permanent miteinander verbindet und eine außerhalb des unteren schalenförmigen Halbkörpers (2) und des oberen schalenförmigen Halbkörpers (3) verlaufende Rohrleitung umfasst, die in Form einer Schraubenfederleitung (17) ausgebildet ist.

2. Vorrichtung nach Anspruch 1,
wobei die Leitung darüber hinaus eine erste, durch den unteren Halbkörper (2) hindurchführende Verbindungsleitung (18) zwischen dem Druckraum (62) im unteren Halbkörper (2) und der Schraubenfederleitung (17) und eine zweite, durch den oberen Halbkörper (3) hindurchführende Verbindungsleitung (19) zwischen dem Druckraum (73) im oberen Halbkörper (3) und der Schraubenfederleitung (17) umfasst.

3. Vorrichtung nach Anspruch 1 oder 2,
wobei die die Druckräume (62, 73) im unteren Halbkörper (2) und im oberen Halbkörper (3) verbindende Leitung frei von Ventilen ist.

4. Vorrichtung nach Anspruch 1, 2 oder 3,
**dadurch gekennzeichnet,**
**dass** der untere Halbkörper (2) und der obere Halbkörper (3) durch ein in einer Ausnehmung (23) an den Halbkörpern angeordnetes Gelenk (20, 21) miteinander verbunden sind.

5. Vorrichtung nach Anspruch 4,
**dadurch gekennzeichnet,**
**dass** die Schraubenfederleitung (17) das Gelenk (20, 21) umfasst oder vom Gelenk (20, 21) umfasst wird.

6. Vorrichtung nach Anspruch 4 oder 5,
**dadurch gekennzeichnet,**
**dass** die Schraubenachse (170) der Schraubenfederleitung (17) mit der Gelenkachse (200) des Gelenks (20, 21) übereinstimmt.

7. Vorrichtung nach einem der Ansprüche 1 bis 6,
**dadurch gekennzeichnet,**
**dass** sie zwei gegenüberliegende Teile (4, 5) eines Verschlusses (45) umfasst, welche die Halbkörper (2, 3) aneinanderdrücken.

8. Vorrichtung nach Anspruch 7,
**dadurch gekennzeichnet,**
**dass** die Ausnehmung (23) von wenigstens einem der zwei gegenüberliegenden Teile (4, 5) des Verschlusses (45) überdeckt wird.

9. Vorrichtung nach Anspruch 7 und nach einem der Ansprüche 4, 5 oder 6, **dadurch gekennzeichnet,**
**dass** die Schraubenfederleitung (17) in der gleichen Ausnehmung (23) wie das Gelenk (20, 21) angeordnet ist und es die Größe der Ausnehmung (23) ermöglicht, sowohl die Schraubenfederleitung (17) als auch das Gelenk (20, 21) aufzunehmen und die beiden gegenüberliegenden Teile (4, 5) des Verschlusses zu verschieben, welche die Halbkörper (2, 3) aneinanderdrücken.

10. Vorrichtung nach einem der voranstehenden Ansprüche,
**dadurch gekennzeichnet,**
**dass** der Innendurchmesser der Schraubenfederleitung (17) die gleiche Öldruckänderungsgeschwindigkeit im unteren und im oberen Halbkörper (2, 3) beim Druckaufbau und -abbau sicherstellt und die Schraubenfederleitung (17) einem Öldruck von mindestens 300 MPa (3000 atm) standhalten kann.

11. Vorrichtung nach einem der voranstehenden Ansprüche,
**dadurch gekennzeichnet,**
**dass** sie eine in den unteren Halbkörper (2) mit der elastischen Membran (6) einsetzbare Spaltkugel umfasst, die aus acht Kugelsektoren (8) besteht, deren abgestumpfte Spitzen einen oktaederförmigen Hohlraum (9) bilden, welcher eine Zuchtkammer (11) beherbergt.

12. Vorrichtung nach Anspruch 11,
**dadurch gekennzeichnet,**
**dass** sie sechs im oktaedrischen Hohlraum (9) platzierbare Kugelsektoren (10) in Form von abgestumpften oktaedrischen Pyramiden umfasst, deren abgestumpfte Spitzen einen Raum in Form von einem Kubus oder einem Quader bilden, in dem die Zuchtkammer (11) angeordnet ist.

13. Vorrichtung nach einem der voranstehenden Ansprüche,
**dadurch gekennzeichnet,**
**dass** sie Folgendes umfasst:
- Stromanschlüsse (12) zur Speisung des Heizkörpers in der Zuchtkammer (11) und/oder
- Messstromanschlüsse (13), um elektrische Signale der in sie eingebauten Temperaturfühler und Druckgeber zu übertragen, und/oder
- eine Öffnung und einen Kanal im oberen Halbkörper (3), um die durch das Öl bei Erstölfüllung der Vorrichtung (1) verdrängte Luft auszulassen, und/oder
- eine Ausnehmung (23) im unteren Halbkörper (2) und eine ähnliche Ausnehmung (23) im oberen Halbkörper (3) zur Aufnahme eines Gelenks (20, 21), das das Öffnen und das Schließen der Vorrichtung (1) sicherstellt, und/oder
- ein Gelenk (20, 21), das an die Halbkörper (2, 3) in der Ausnehmung (23) angeschlossen wird.

14. Vorrichtung nach einem der voranstehenden Ansprüche,
**dadurch gekennzeichnet,**
**dass**
- die Schraubenfederleitung (17) einen Ölbypass zwischen den Halbkörpern sicherstellt,
- die Schraubenfederleitung (17) auf Verdrillung und Rückverdrehung beansprucht wird, so dass der obere Halbkörper (3) am Gelenk hoch- und zugeklappt werden kann,
- **dass** jeder der Halbkörper (2, 3) je eine zusätzliche Öffnung und je einen Kanal aufweist, um die Schraubenfederleitung (17) anzuschließen und den Ölfluss zwischen der Schraubenfederleitung (17) und dem durch den unteren Halbkörper (2) und die elastische Membran (6) gebildeten Druckraum (62) und dem durch den oberen Halbkörper (3) und die elastische Membran (7) gebildeten Druckraum (73) zu ermöglichen.

15. Vorrichtung nach einem der voranstehenden Ansprüche,
**dadurch gekennzeichnet,**
**dass** sie zum Züchten synthetischer Diamanten vorgesehen ist.

## Claims

1. A device (1) for generating high pressures in solid and liquid media, including:
- a lower shell-shaped body half (2) and an upper shell-shaped body half (3),
- a lower elastic membrane (6) and an upper elastic membrane (7), which are each inserted into the lower body half (2) and into the upper body half (3), and the respective body half (2, 3) and the respective membrane (6, 7) inserted into its each surround a pressure chamber (62, 73),
- an opening and a channel (14) in the lower body half (2), in order to attach an oil line from an oil pump to the device and to pump the oil into the pressure chamber between the lower body half (2) and the elastic membrane (6) inserted into it, wherein the pressure chambers (62, 73) in the lower body half (2) and in the upper body half (3) communicate by means of a line,
***characterized in that***
the line connects the pressure chambers (62, 73) in the lower body half (2) and the upper body half (3) permanently with one another in both the open and the closed state of the device and includes a pipeline, which is embodied in the form of a helical spring line (17) and extends outside the lower shell-shaped body half (2) and the upper shell-shaped body half (3).

2. The device of claim 1,
wherein the line furthermore includes a first connection line (18), extending through the lower body half (2) and between the pressure chamber (62) in the lower body half (2) and the helical spring line (17), and a second connection line (19), extending through the upper body half (3) and between the pressure chamber (73) in the upper body half (3) and the helical spring line (17).

3. The device of claim 1 or 2,
wherein the line connecting the pressure chambers (62, 73) in the lower body half (2) and in the upper body half (3) is valveless.

4. The device of claim 1, 2 or 3,
***characterized in that***
the lower body half (2) and the upper body half (3) communicate with one another through a joint (20, 21), located on the body halves in a recess (23).

5. The device of claim 4,
***characterized in that***
the helical spring line (17) includes the joint (20, 21), or the joint (20, 21) includes it.

6. The device of claim 4 or 5,
***characterized in that***
the helical axis (170) of the helical spring line (17) coincides with the joint axis (200) of the joint (20, 21).

7. The device of one of claims 1 through 6,
***characterized in that***
it includes two opposed parts (4, 5) of a fastener (45), which press the body halves (2, 3) against one another.

8. The device of claim 7,
***characterized in that***
the recess (23) is covered by at least one of the two opposed parts (4, 5) of the fastener (45).

9. The device of claim 7 and of one of claims 4, 5 or 6,
***characterized in that***
the helical spring line (17) is located in the same recess (23) as the joint (20, 21) and the size of the recess (23) makes it possible to receive both the helical spring line (17) and the joint (20, 21) and to displace the two opposed parts (4, 5) of the fastener that press the body halves (2, 3) against one another.

10. The device of one of the foregoing claims,
***characterized in that***
the inside diameter of the helical spring line (17) ensures the same rate of change in oil pressure in the lower and upper body halves (2, 3) upon pressure buildup and reduction, and the helical spring line (17) can withstand an oil pressure of at least 300 MPa (3000 atm)

11. The device of one of the foregoing claims,
***characterized in that***
it includes a split sphere, which can be inserted into the lower body half (2) with the elastic membrane (6), which split sphere consists of eight sphere sectors (8), the truncated peaks of which form an octahedral void (9), which accommodates a growth chamber (11).

12. The device of claim 11,
***characterized in that***
it includes six sphere sectors (10) in the form of truncated octahedral pyramids, which can be placed in the octahedral void (9) and the truncated peaks of which form a chamber, in the form of a cube or cuboid, in which the growth chamber (11) is located.

13. The device of one of the foregoing claims,
***characterized in that***
it includes the following:
- bus bars (12) for supplying power to the heater in the growth chamber (11) and/or
- measurement current conductors (13), in order to transmit electrical signals of the temperature sensor and pressure indicator built into them, and/or
- an opening and a channel in the upper body half (3), in order to expel air that is forced out by the oil the first time the device (1) is filled with oil, and/or
- a recess (23) in the lower body half (2) and a similar recess (23) in the upper body half (3) for receiving a joint (20, 21) that ensures the opening and closing of the device (1), and/or
- a joint (20, 21), which is connected to the body halves (2, 3) in the recess (23).

14. The device of one of the foregoing claims,
***characterized in that***
- the helical spring line (17) ensures an oil bypass between the body halves,
- the helical spring line (17) is subjected to stress with regard to twisting and reversed rotation, so that the upper body half (3) can be flipped open and shut at the joint,
- that each of the body halves (2, 3) has one additional opening each and one channel, in order to attach the helical spring line (17) and to enable the oil flow between the helical spring line (17) and the pressure chamber (62) formed by the lower body half (2) and the elastic membrane (6) and the pressure chamber (73) formed by the upper body half (3) and the elastic membrane (7).

15. The device of one of the foregoing claims,
***characterized in that***
it is provided for growing synthetic diamonds.

## Revendications

1. Dispositif (1) pour la production de fortes pressions dans des supports fixes et fluides comportant :
- Un demi-corps inférieur en forme coquille (2) et un demi-corps supérieur en forme coquille (3),
- Un membrane inférieure élastique (6) et un membrane supérieure élastique (7) qui sont respectivement intégrés dans le demi-corps inférieur en forme coquille (2) et dans le demi-corps supérieure en forme de coquille (3) où le demi-corps respectif (2,3) et le membrane intégré en lui (6,7) contournent le cas échéant une chambre de pression (62, 73),
- Une ouverture et un canal (14) dans le demi-corps inférieur (2) pour rejoindre l'oléoduc d'une pompe à huile au dispositif et pour promouvoir l'huile dans la chambre de pression entre le demi-corps inférieur (2) et le membrane élastique intégré en lui (6),
Où les chambres de pression (62,73) sont reliées dans le demi-corps inférieur (2) et dans le demi-corps supérieur (3) par le biais d'un conduit,
Est caractérisé de sorte que
Le conduit relie à titre permanent les chambres de pression (62,73) dans le demi-corps inférieur (2) et dans le demi-corps supérieur (3) que ce soit dans l'état ouvert ou fermé du dispositif et comporte à l'extérieur du demi-corps inférieur en forme coquille (2) et du demi-corps supérieur en forme de coquille (3) un conduit étendu formé en qualité d'un conduit de ressort à boudin.

2. Dispositif selon la revendication 1 où le conduit comporte également une première ligne de liaison passant par le demi-corps inférieur (2) entre la chambre de pression (62) dans le demi-corps inférieur (2) et le conduit de ressort à boudin (17) et une deuxième ligne de liaison passant par le demi-corps supérieur (3) entre la chambre de pression (73) dans le demi-corps supérieur (3) et le conduit de ressort à boudin (17).

3. Dispositif selon la revendication 1 ou 2 où le conduit reliant les chambres de pression (62,73) dans le demi-corps inférieur (2) et le demi-corps supérieur (3) est exempte de soupapes.

4. Dispositif selon la revendication 1, 2 ou 3 où le demi-corps inférieur (2) et le demi-corps supérieur (3) sont reliés par une charnière (20,21) disposée à un creux (23) aux demi-corps (2,3).

5. Dispositif selon la revendication 4 est caractérisé de sorte que le conduit de ressort à boudin (17) comporte la charnière (20,21) ou est comporté respectivement par la charnière (20,21).

6. Dispositif selon la revendication 4 ou 5 est caractérisé de sorte que l'axe de l'hélice (170) du conduit de ressort à boudin (17) est concordant avec l'axe de la charnière (200) de la charnière (20,21).

7. Dispositif selon l'une des revendications 1 jusqu'à 6 est caractérisé de sorte qu'il comporte deux partis opposés (4,5) d'une fermeture (45) permettant le serrage des demi-corps (2,3).

8. Dispositif selon la revendication 7 est caractérisé de sorte que le creux (23) est couvert au minimum par l'une des deux partis opposés (4,5) de la fermeture (45).

9. Dispositif selon la revendication 7 est selon l'une des revendications 4,5 ou 6 est caractérisé de sorte que le conduit de ressort à boudin (17) est disposé dans le même creux (23) comme la charnière (20,21) et que ce dernier et en fonction de la taille du creux (23) rend possible non seulement l'insertion du conduit de ressort à boudin (17) mais aussi de la charnière (20,21) et de procéder au déplacement des deux partis opposés (4,5) de la fermeture (45) qui permettent le serrage des demi-corps (2,3).

10. Dispositif selon l'une des revendications précédentes est caractérisé de sorte que le diamètre interne du conduit de ressort à boudin (17) garantit la même vitesse de changement de pression de l'huile dans le demi-corps inférieur et supérieur (2,3) lors de la mise en pression et lors de la dépressurisation et que le conduit de ressort à boudin (17) peut supporter une pression d'huile au minimum de 300 MPa (3000 atm).

11. Dispositif selon l'une des revendications précédentes est caractérisé de sorte qu'il comporte une boule de fente intégrée avec le membrane élastique (6) dans le demi-corps inférieur (2) contenant huit secteurs coulissants (8) dont les pointes tronquées forment une cavité octaèdre (9) hébergeant une chambre de reproduction (11).

12. Dispositif selon la revendication 11 est caractérisé de sorte qu'il comporte six secteurs coulissants (10) déplaçables dans la cavité octaèdre (9) sous forme de pyramides tronquées octaèdres dont les pointes tronquées forment un espace sous forme de cube ou de parallélépipède où la chambre de reproduction (11) est disposée.

13. Dispositif selon l'une des revendications précédentes est caractérisé de sorte qu'il comporte ce qui suit :
- des connexions électriques (12) pour l'alimentation du radiateur dans la chambre de reproduction (11) et/ou
- des connexions électriques de mesure (13) pour transmettre des signaux électriques vers le capteur de température et le capteur de pression intégrés et/ou
- une ouverture et un canal dans le demi-corps supérieur (3) pour décharger l'air refoulé par l'huile lors du premier remplissage d'huile du dispositif (1) et/ou
- un creux (23) dans le demi-corps inférieur (2) et un creux semblable (23) dans le demi-corps supérieur (3) pour l'insertion d'une charnière (20,21) garantissant l'ouverture et la fermeture du dispositif (1) et/ou
- une charnière (20,21) se connectant aux demi-corps (2,3) dans le creux (23).

14. Dispositif selon l'une des revendications précédentes est caractérisé de sorte que
- le conduit de ressort à boudin (17) garantit le passage de l'huile entre les demi-corps,
- e conduit de ressort à boudin (17) est revendiqué sur torsion et rotation de sorte que le demi-corps supérieur (3) est replié et fermé au niveau de la charnière,
- que chaque des demi-corps (2,3) présente une ouverture supplémentaire et un canal pour rejoindre le conduit de ressort à boudin (17) et faciliter l'écoulement de l'huile entre le conduit de ressort à boudin (17) et la chambre de pression (62) formée entre le demi-corps inférieur (2) et le membrane élastique (6) ainsi que la chambre de pression formée entre le demi-corps supérieur (3) et le membrane élastique (7).

15. Dispositif selon l'une des revendications précédentes est caractérisé de sorte qu'il est prévu pour la culture de diamants synthétiques.
